# FASCICULE DE BREVET EUROPEEN

(11) **EP 4 036 916 B1**
(45) Date de publication et mention de la délivrance du brevet: **15.10.2025**
(21) Numéro de dépôt: 22152366.5
(22) Date de dépôt: 20.01.2022
(51) Int. Cl.: G11C 7/10, G11C 16/10

(54) **DISPOSITIF COMPORTANT UN CIRCUIT MÉMOIRE NON VOLATILE**
VORRICHTUNG MIT EINEM NICHT-FLÜCHTIGEN SPEICHERSCHALTKREIS
DEVICE COMPRISING A NON-VOLATILE MEMORY CIRCUIT

(30) Priorité: 29.01.2021 FR 2100866
(43) Date de publication de la demande: 03.08.2022
(73) Titulaire: Commissariat à l'Energie Atomique et aux Energies Alternatives, 75015 Paris (FR); Centre national de la recherche scientifique, 75016 Paris (FR); Université d'Aix Marseille, 13007 Marseille 7 (FR)
(72) Inventeur: EGLOFF, Valentin, 38054 Grenoble Cedex 09 (FR); NOEL, Jean-Philippe, 38054 Grenoble Cedex 09 (FR); PORTAL, Jean-Michel, 13119 Saint-Savournin (FR)
(74) Mandataire: Cabinet Beaumont

(56) Documents cités:
- WO-A2-2013/016723
- US-A1- 2013 346 671
- US-A1- 2018 107 406
- US-B1- 10 216 685

## Description

### Domaine technique

La présente description concerne de façon générale le domaine des circuits mémoire, et vise plus particulièrement le domaine des circuits mémoire non volatiles.

### Technique antérieure

Une limitation connue des circuits mémoire non volatiles est leur endurance relativement faible, c'est-à-dire le nombre maximal relativement faible de cycles d'écriture que peut supporter chaque cellule élémentaire de stockage.

Il serait souhaitable de pouvoir améliorer au moins en partie certains aspects des circuits mémoire non volatiles.

Les documents US 2018/107406 A1, WO 2013/016723 A2, US 10 216 685 B1, US 2013/346671 A1 décrivent des dispositifs de type mémoire.

### Résumé de l'invention

Conformément à la présente invention, un dispositif, selon la revendication 1, est fourni. Des modes de réalisation préférés de l'invention sont exposés dans les revendications dépendantes.

### Brève description des dessins

Ces caractéristiques et avantages, ainsi que d'autres, seront exposés en détail dans la description suivante de modes de réalisation particuliers faite à titre non limitatif en relation avec les figures jointes parmi lesquelles :
la figure 1 représente de façon schématique, sous forme de blocs, un exemple d'un dispositif mémoire ; et
la figure 2 représente de façon schématique, sous forme de blocs, un exemple d'un dispositif mémoire selon un mode de réalisation.

### Description des modes de réalisation

De mêmes éléments ont été désignés par de mêmes références dans les différentes figures. En particulier, les éléments structurels et/ou fonctionnels communs aux différents modes de réalisation peuvent présenter les mêmes références et peuvent disposer de propriétés structurelles, dimensionnelles et matérielles identiques.

Par souci de clarté, seuls les étapes et éléments utiles à la compréhension des modes de réalisation décrits ont été représentés et sont détaillés. En particulier, la réalisation des différents éléments des dispositifs mémoire décrits n'a pas été détaillée, la réalisation de ces éléments étant à la portée de la personne du métier à partir des indications de la présente description. En particulier, la réalisation de circuits mémoire adaptés à mettre en oeuvre des opérations de calcul n'a pas été détaillée.

Sauf précision contraire, lorsque l'on fait référence à deux éléments connectés entre eux, cela signifie directement connectés sans éléments intermédiaires autres que des conducteurs, et lorsque l'on fait référence à deux éléments reliés (en anglais "coupled") entre eux, cela signifie que ces deux éléments peuvent être connectés ou être reliés par l'intermédiaire d'un ou plusieurs autres éléments.

Sauf précision contraire, les expressions "environ", "approximativement", "sensiblement", et "de l'ordre de" signifient à 10 % près, de préférence à 5 % près.

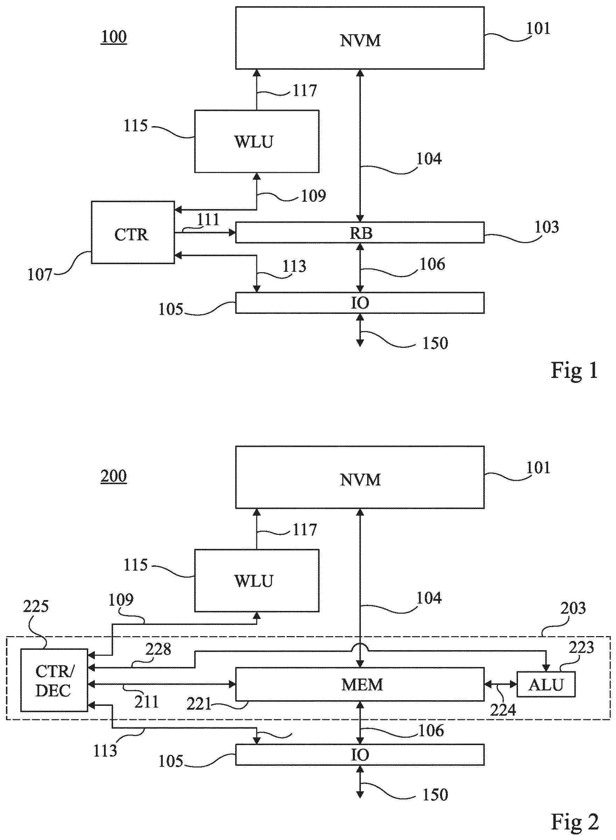

Selon un aspect des modes de réalisation décrits, on prévoit un dispositif mémoire comportant une matrice de cellules mémoire non volatiles, et, couplé à la matrice de cellules mémoire non volatiles, un circuit mémoire tampon comprenant une matrice de cellules mémoire volatiles, ce circuit étant adapté à mettre en oeuvre des fonctions de calcul. Ceci permet de rendre "intelligente" la mémoire non volatile, c'est-à-dire de lui adjoindre des capacités de calcul, tout en tenant compte des spécificités des mémoires non volatiles, et notamment leur relativement faible endurance, c'est-à-dire le nombre maximal relativement faible de cycles d'écriture que peut supporter chaque cellule mémoire non volatile. En particulier, la prévision d'un circuit tampon à base de cellules mémoire volatiles, adapté à mettre en oeuvre des fonctions de calcul, permet de limiter les accès à la matrice de cellules mémoire non volatiles, et donc de limiter l'usure de la matrice de cellules mémoire non volatiles, comme cela sera décrit plus en détail par la suite, notamment en relation avec la figure 2.

La figure 1 représente de façon schématique, sous forme de blocs, un exemple d'un dispositif mémoire 100 comportant un circuit mémoire non volatile 101 (NVM).

Le circuit 101 comprend une matrice de cellules mémoire élémentaires non volatiles. Le circuit 101 est par exemple un circuit de type SCM (de l'anglais "Storage Class Memory" - mémoire de catégorie de stockage). A titre d'exemple, le circuit 101 est un circuit mémoire résistif, par exemple un circuit de type RRAM ou ReRAM (de l'anglais "Resistive Random Access Memory" - mémoire résistive à accès aléatoire), ou un circuit mémoire à changement de phase (PCM - de l'anglais "Phase Change Memory"), ou un circuit mémoire magnétique, par exemple un circuit de type MRAM (de l'anglais "Magnetic Random Access Memory" - mémoire magnétique à accès aléatoire).

Le dispositif 100 comprend en outre un circuit mémoire tampon 103 (RB), aussi appelé tampon de ligne ("row buffer" en anglais), relié au circuit mémoire non volatile 101 par une première liaison de transfert de données bidirectionnelle 104. Le circuit mémoire tampon est par exemple un circuit mémoire volatile, par exemple de type SRAM (de l'anglais "Static Random Access Memory" - mémoire statique à accès aléatoire). Le circuit mémoire tampon 103 comprend une rangée de cellules mémoire élémentaires. Cette rangée a par exemple la même largeur qu'une rangée de la matrice de cellules élémentaires du circuit mémoire 101. La liaison de transfert de données 104 a de préférence une largeur égale à la taille du plus grand vecteur de données pouvant être lu en une fois dans le circuit mémoire 101, par exemple égale à la taille d'une rangée de circuits de lecture présents en pieds de colonnes dans le circuit mémoire 101, par exemple comprise dans la plage allant de 512 bits (64 octets) à 32768 bits (4096 octets).

Le dispositif 100 comprend de plus un circuit d'entrée-sortie 105 (IO) relié au circuit mémoire tampon 103 par l'intermédiaire d'une deuxième liaison de transfert de données bidirectionnelle 106. Le circuit d'entrée-sortie 105 est destiné à être relié à un bus système externe 150. Le bus système externe 150 peut lui-même être relié à un ou plusieurs processeurs et/ou à un ou plusieurs autres circuits mémoire, non représentés. A titre d'exemple, le bus système 150 a une largeur de données égale à la largeur de la liaison de transfert de données 106. La liaison de transfert de données 104 a de préférence une largeur supérieure à la largeur de la liaison 106 et à la largeur de données du bus système 150. A titre d'exemple, la largeur de la liaison 106 et la largeur de données du bus système 150 sont comprises dans la plage allant de 32 à 256 bits. Le circuit mémoire tampon 103 est alors adapté à sérialiser les données entre la liaison 104 et la liaison 106.

Le dispositif 100 comprend en outre un circuit de contrôle 107 (CTR). Le circuit de contrôle 107 est relié au circuit mémoire non volatile 101 par l'intermédiaire d'une liaison de contrôle 109 (et, dans cet exemple, d'un circuit de gestion d'usure 115 décrit plus en détail ci-après), au circuit mémoire tampon 103 par une liaison de contrôle 111, et au circuit d'entrée-sortie 105 par une liaison de contrôle 113.

Le circuit de contrôle 107 est adapté à recevoir des instructions en provenance d'une unité de contrôle externe, par exemple un processeur, via le bus système 150, le circuit d'entrée-sortie 105, et la liaison 113, et à commander les circuits 101, 103 et 105 pour exécuter les opérations demandées.

Le circuit de contrôle 107 est notamment adapté à commander des transferts de données du circuit mémoire non volatile 101 vers le circuit mémoire tampon 103, via la liaison 104, puis du circuit mémoire tampon 103 vers le circuit d'entrée-sortie 105, via la liaison 106. Le circuit de contrôle 107 est en outre adapté à commander des transferts de données du circuit d'entrée-sortie 105 vers le circuit mémoire tampon 103, via la liaison 106, puis du circuit mémoire tampon 103 vers le circuit mémoire non volatile 101, via la liaison 104.

Dans l'exemple de la figure 1, le dispositif 100 comprend en outre un circuit de gestion d'usure 115 (WLU). Le circuit 115 est adapté à convertir des adresses appelées adresses utilisateur reçues en provenance du circuit de contrôle 107, en des adresses dites adresses physiques correspondant aux adresses effectives des données dans le circuit mémoire non volatile 101. Pour cela, le circuit 115 peut contenir une ou plusieurs tables de traduction d'adresse. Le rôle du circuit 115 est d'équilibrer les accès aux différentes cellules du circuit mémoire, de façon transparente pour l'utilisateur. Le circuit 115 fait interface entre la liaison 109 et le circuit mémoire non volatile 101. Les adresses utilisateurs sont reçues par le circuit 115 via la liaison 109, et sont traduites en adresses physiques transmises au circuit mémoire non volatile 101 via une liaison 117 reliant le circuit 115 au circuit 101.

La figure 2 représente de façon schématique, sous forme de blocs, un exemple d'un dispositif mémoire 200 selon un mode de réalisation.

Le dispositif mémoire 200 de la figure 2 comprend des éléments communs avec le dispositif mémoire 100 de la figure 1. Ces éléments ne seront pas détaillés à nouveau ci-après. Dans la suite, seules les différences par rapport au dispositif mémoire 100 de la figure 1 seront mises en exergue.

Le dispositif mémoire 200 de la figure 2 diffère du dispositif mémoire 100 de la figure 1 principalement en ce que, dans le dispositif mémoire 200, le circuit mémoire tampon 103 et le circuit de contrôle 107 du dispositif mémoire 100 ont été remplacés par un circuit mémoire tampon 203.

Le circuit mémoire tampon 203 comprend une matrice 221 (MEM) de plusieurs rangées de cellules élémentaires de stockage volatiles, par exemple des cellules SRAM. Chaque rangée de la matrice 221 a par exemple la même largeur ou sensiblement la même largeur qu'une rangée de la matrice de cellules élémentaires du circuit mémoire non volatile 101. A titre d'exemple, chaque rangée de la matrice 221 comprend quelques bits de contrôle supplémentaires, par exemple un à deux bits de validité et/ou de suivi des modifications par rapport à une rangée de la matrice de cellules élémentaires du circuit mémoire non volatile 101. La liaison de transfert de données 104 a de préférence une largeur égale à la taille du plus grand vecteur de données pouvant être lu en une fois dans la matrice 221, par exemple égale à la taille d'une rangée de circuits de lecture présents en pieds de colonnes dans la matrice 221.

Un avantage lié à l'utilisation d'une mémoire tampon (matrice 221) de type SRAM est que les mémoires SRAM ont une consommation énergétique relativement faible par rapport à d'autres types de mémoires volatiles, par exemple des mémoires DRAM (de l'anglais "Dynamic Random Access Memory" - mémoire dynamique à accès aléatoire).

On notera en outre que les mémoires DRAM doivent être rafraichies à chaque cycle et nécessitent par conséquent un circuit de contrôle relativement complexe et encombrant pour gérer ces rafraichissements, ce qui n'est pas le cas des mémoires SRAM.

De plus, du fait des rafraichissements à chaque cycle, les mémoires DRAM présentent un temps d'accès en lecture significativement plus long que les mémoires SRAM. Ainsi, dans le cas où l'on cherche à accéder en lecture à une donnée dite manquante, c'est-à-dire présente dans le circuit mémoire non volatile 101 mais non présente dans le circuit mémoire tampon 203, le temps d'accès à la donnée (temps de lecture dans la mémoire tampon + temps de lecture dans la mémoire non volatile) sera significativement plus court avec une mémoire tampon de type SRAM qu'avec une mémoire tampon de type DRAM.

Par ailleurs, un avantage des mémoires SRAM est que leur procédé de fabrication est compatible avec celui des circuits CMOS (de l'anglais "Complementary Metal Oxide Semiconductor" - métal oxyde semiconducteur complémentaire) et des circuits mémoire non volatiles. Dans un mode de réalisation préféré, le circuit mémoire tampon 203 et le circuit mémoire non volatile 101 sont intégrés sur une même puce de circuits intégrés.

La liaison de données 104 est connectée d'une part à un port d'entrée-sortie de données de la matrice de cellules mémoire 221, et d'autre part à un port d'entrée-sortie de données du circuit mémoire 101. La liaison de données 106 est connectée d'une part à un port d'entrée-sortie de données du circuit mémoire 221, et d'autre part au circuit d'entrée-sortie 105 du dispositif.

Le circuit 203 est adapté à réaliser des calculs ayant pour opérandes des données stockées dans la matrice de cellules élémentaires de stockage 221, et à réécrire le résultat des calculs dans cette même matrice 221. Le résultat d'un calcul peut ensuite être écrit dans le circuit mémoire non volatile 101 via la liaison de données 104, ou transmis au circuit d'entrée-sortie 105 via la liaison de données 106, ou encore conservé uniquement dans le circuit 221 pour servir d'opérande pour une opération de calcul ultérieure.

Plus particulièrement, dans l'exemple de la figure 2, le circuit mémoire tampon 203 comprend en outre un circuit de calcul 223 (ALU). Le circuit de calcul 223 est relié à un port d'entrée-sortie de données de la matrice de cellules mémoire 221 par une liaison de données bidirectionnelle 224, par exemple de même largeur ou sensiblement de même largeur que la liaison de données 104. Le circuit de calcul 223 est de préférence un circuit de calcul vectoriel, c'est-à-dire adapté à mettre en oeuvre des opérations de calcul ayant des opérandes vectoriels, par exemple de largeur égale à la largeur de la liaison de données 224. Lors d'une opération de calcul, les opérandes sont lus dans la matrice 221 et transmis au circuit de calcul 223 via la liaison 224. Le résultat de l'opération peut être retransmis à la matrice 221 via la liaison 224, et réécrit dans la matrice 221.

Le circuit mémoire tampon comprend un circuit de contrôle 225 (CTR/DEC). Le circuit 225 est, dans cet exemple, adapté à mettre en oeuvre des fonctions similaires à celles du circuit 107 de la figure 1. En particulier, le circuit de contrôle 225 est adapté à commander des transferts de données du circuit mémoire non volatile 101 vers le circuit mémoire tampon 203 et, plus particulièrement, vers la matrice de cellules élémentaires de stockage 221 du circuit mémoire tampon 203, via la liaison 104, puis du circuit mémoire tampon 203, et, plus particulièrement, de la matrice de cellules élémentaires de stockage 221 du circuit mémoire tampon 203 vers le circuit d'entrée-sortie 105, via la liaison 106. Le circuit de contrôle 225 est en outre adapté à commander des transferts de données du circuit d'entrée-sortie 105 vers le circuit mémoire tampon 203 et, plus particulièrement, vers la matrice de cellules élémentaires de stockage 221 du circuit mémoire tampon 203, via la liaison 106, puis du circuit mémoire tampon 203 et, plus particulièrement, de la matrice de cellules élémentaires de stockage 221 du circuit mémoire tampon 203, vers le circuit mémoire non volatile 101, via la liaison 104.

Pour cela, de façon similaire à ce qui a été décrit en relation avec la figure 1, le circuit de contrôle 225 est relié au circuit mémoire non volatile 101 par l'intermédiaire d'une liaison de contrôle 109 (et, dans cet exemple, du circuit de gestion d'usure 115), et au circuit d'entrée-sortie 105 par une liaison de contrôle 113. Le circuit de contrôle 225 est en outre relié à la matrice de cellules mémoire volatiles 221 par une liaison de contrôle 211.

Dans le mode de réalisation de la figure 2, le circuit de contrôle 225 est en outre adapté à commander l'exécution de calculs au sein du circuit mémoire tampon 203. Pour cela, le circuit 225 est adapté à envoyer et recevoir des signaux de contrôle via la liaison 211. Le circuit de contrôle 225 est de plus adapté à envoyer des signaux de contrôle au circuit de calcul 223 via une liaison de contrôle 228.

Le circuit de contrôle 225 reçoit des instructions de lecture, d'écriture et de calcul en provenance d'une unité de contrôle externe, par exemple un processeur, via le bus système 150, le circuit d'entrée-sortie 105, et la liaison 113. Ces instructions sont décodées puis exécutées par le circuit de contrôle 225. Plus particulièrement, le circuit de contrôle 225 commande les circuits 101, 221, 223 et 105 pour exécuter les opérations demandées.

En pratique, des séries de plusieurs opérations de calcul successives peuvent être mises en oeuvre au sein du circuit mémoire tampon 203, sans écrire les résultats intermédiaires dans le circuit mémoire non volatile 101. A la fin des calculs, seuls les résultats finaux peuvent éventuellement être écrits dans le circuit mémoire 101. Ceci permet de limiter le nombre d'accès, en particulier le nombre d'écriture, et donc l'usure du circuit mémoire non volatile 101.

Le circuit de contrôle 225 est adapté à décomposer, si nécessaire, chaque instruction reçue en une séquence de plusieurs sous-opérations aussi appelées opérations élémentaires. Par opération élémentaire, on entend une opération de lecture, d'écriture ou de calcul. Une opération de calcul peut éventuellement consister à simplement actionner le circuit de calcul 223. Une opération de calcul peut également consister à réaliser une opération de lecture d'une ou plusieurs rangées puis à actionner le circuit de calcul 223. De façon générale, on peut considérer qu'une opération élémentaire peut être réalisée dans un cycle d'accès à la matrice 221. Les instructions envoyées par le circuit de contrôle 225 peuvent être des instructions simples correspondant à une unique requête d'écriture ou de lecture dans la matrice 221 sans opérations de calcul, ou peuvent être des instructions complexes pouvant nécessiter en pratique l'exécution de plusieurs opérations élémentaires de lecture, écriture ou calcul. Ainsi, le circuit 225 va procéder à une décomposition d'une instruction reçue en une séquence de plusieurs opérations élémentaires uniquement quand il reçoit une instruction complexe (ou « smart instruction » en anglais). Les instructions complexes sont, après décodage, transformées en un flux d'opérations élémentaires, ou autrement dit une séquence d'opérations élémentaires. Par exemple, si une instruction complexe correspond à l'opération logique "ET" entre deux opérandes et à la mise en mémoire du résultat, la séquence élémentaire correspondant à cette instruction complexe va par exemple correspondre à 1) lire un premier opérande dans la matrice mémoire 221, 2) lire un deuxième opérande dans la matrice mémoire 221, 3) calculer l'opération logique "ET" au moyen du circuit 223, et 4) écrire le résultat dans la matrice mémoire 221.

Le format des instructions reçues du processeur via le circuit d'entrée-sortie 105 est par exemple similaire à ce qui a été décrit dans la demande de brevet EP3503103 précédemment déposée par le demandeur. En particulier, pour ce qui est des instructions de calcul, chaque instruction peut comprendre un premier champ définissant un type d'opération à mettre en oeuvre, un deuxième champ définissant les adresses des opérandes, et un troisième champ définissant une adresse de réécriture du résultat de l'opération.

De façon préférentielle, la matrice 221 de cellules mémoire du circuit mémoire tampon 203 est gérée de façon similaire à une mémoire cache. Cela signifie que tant que cela est possible, c'est-à-dire tant que la matrice 221 contient suffisamment d'espace, les données transitant dans le circuit mémoire tampon 203 restent stockées dans la matrice 221. Ainsi, ces données sont accessibles directement par le processeur ou le circuit de calcul 223, sans avoir à accéder à la mémoire non volatile 101. Les données contenues dans le circuit mémoire tampon 203 sont écrites dans le circuit mémoire non volatile 101 uniquement lorsque le circuit mémoire tampon est plein, et que les lignes correspondantes de la matrice 221 doivent être libérées pour accueillir de nouvelles données. Ceci permet de limiter le nombre d'accès en lecture et en écriture au circuit mémoire non volatile 101, et ainsi de limiter l'usure du circuit mémoire non volatile 101. Ainsi, chaque fois qu'une donnée de la mémoire non volatile 101 est demandée en lecture, que ce soit pour mettre en oeuvre un calcul ou pour lire la donnée depuis l'extérieur du dispositif, via le circuit d'entrée-sortie 105, le circuit de contrôle vérifie d'abord, via la liaison 211 bidirectionnelle, si cette donnée est présente dans le circuit mémoire 221. Si la donnée est présente, elle peut être lue directement dans le circuit mémoire 221. Si la donnée est absente du circuit mémoire 221, la donnée est lue dans le circuit mémoire non volatile 101 et écrite dans le circuit mémoire 221 avant d'être envoyée au demandeur (qui peut être le circuit de calcul 223 ou le circuit d'entrée-sortie 105). Le circuit mémoire volatile 221 du circuit mémoire tampon 203 n'est pas mappé en mémoire, c'est-à-dire que ses adresses ne sont pas directement accessibles par un dispositif extérieur.

Dans le cas d'une écriture (écriture du résultat d'une opération de calcul réalisée par le circuit de calcul 223 ou écriture d'une donnée reçue de l'extérieur via le circuit d'entrée-sortie 105), la donnée est d'abord écrite dans le circuit mémoire 221. L'écriture dans la mémoire non volatile 101 peut être déclenchée par le circuit de contrôle lorsque le circuit mémoire tampon 203 est plein et que des lignes de la matrice 221 doivent être libérées, par exemple lorsqu'une ligne complète de donnée est prête à être écrite dans le circuit mémoire 101, ou lorsque le résultat final d'une séquence de calculs est prêt à être écrit dans le circuit mémoire 101.

Le circuit mémoire tampon 203 comporte de préférence une table de correspondance des adresses et de suivi de validité des données stockées dans le circuit mémoire 221. Cette table (non détaillée sur la figure) est par exemple stockée dans le circuit 221 lui-même, ou dans une mémoire du circuit de contrôle 225. Cette table est exploitée par le circuit de contrôle 225 pour déterminer si les données adressées sont présentes dans le circuit 221 ou si elles doivent être lues ou écrites dans le circuit mémoire 101.

Le dispositif mémoire 200 de la figure 2 forme un dispositif mémoire "intelligent", c'est-à-dire adapté non seulement à stocker des données, dans la mémoire non volatile 101, mais également à mettre en oeuvre des opérations de calcul dans le circuit mémoire tampon 203. Ce dispositif peut être contrôlé par un processeur extérieur via le circuit d'entrée-sortie 105. Le processeur peut envoyer des instructions simples de lecture ou d'écriture, ou des instructions complexes, comprenant notamment des instructions de calcul. Ces instructions sont décodées et exécutées par le circuit de contrôle 225. Seule la mémoire non volatile 101 est adressable par le processeur. La mémoire volatile 221 n'est pas mappée, c'est-à-dire que ses adresses ne sont pas directement accessibles par le processeur. Autrement dit, la mémoire volatile 221 n'est pas visible par le processeur. Les transferts de données entre la mémoire non volatile 101 et la mémoire volatile 221 sont gérés par le circuit de contrôle 225 (et non par le système extérieur) de façon à minimiser les accès à la mémoire non volatile 101 et ainsi limiter l'usure de la mémoire 101. A titre d'exemple, des écritures dans la mémoire non volatile 101 sont réalisées uniquement lorsque la mémoire volatile 221 est pleine. Ainsi, plus la taille de la mémoire volatile 221 est importante, plus le nombre d'accès en lecture ou en écriture à la mémoire non volatile 101 peut être réduit. Ainsi, vu de l'extérieur, le dispositif mémoire 200 correspond à un dispositif mémoire intelligent esclave, par exemple adressable de façon similaire à ce qui a été décrit dans la demande de brevet EP3503103 susmentionnée.

Dans l'exemple de la figure 2, le circuit mémoire non volatile 101 comprend uniquement une matrice de cellules élémentaires de stockage non volatiles ainsi que des circuits périphériques de lecture et écriture de données dans la matrice. A titre de variante, l'ensemble comportant le circuit mémoire 101 et le circuit de gestion d'usure 115 peut être remplacé par un dispositif mémoire non volatile complet du type décrit en relation avec la figure 1. Dans ce cas, la liaison 109 relie le circuit de contrôle 225 directement au circuit d'entrée-sortie du dispositif mémoire non volatile. Les signaux générés par le circuit 225 pour contrôler le dispositif mémoire non volatile peuvent être adaptés en conséquence.

Divers modes de réalisation et variantes ont été décrits. La personne du métier comprendra que certaines caractéristiques de ces divers modes de réalisation et variantes pourraient être combinées, et d'autres variantes apparaîtront à la personne du métier. On notera en particulier que le code à exécuter par le dispositif mémoire peut être stocké dans une mémoire de stockage de programme interne au dispositif, par exemple le circuit mémoire volatile 221 ou dans une autre mémoire interne non détaillée sur les figures, accessible directement par le circuit de contrôle 225. Dans ce cas, le processeur externe peut se contenter d'envoyer des signaux de synchronisation, par exemple une instruction de démarrage d'une tâche. Ceci permet de diminuer le trafic entre le processeur externe et le dispositif mémoire.

Par ailleurs, le circuit de calcul 223 peut être spécialisé en fonction du type de traitement que l'on souhaite effectuer.

En outre, le circuit mémoire tampon intelligent 203 décrit en relation avec la figure 2 peut être adapté, notamment en remplaçant l'ensemble formé par le circuit mémoire volatile 221 et le circuit de calcul 223 par d'autres types de circuits mémoire volatiles intelligents, c'est-à-dire adaptés à mettre en oeuvre des fonctions de calcul, par exemple des circuits mémoire intelligents du type décrit dans les demandes de brevet EP3252774 et EP3503103 précédemment déposées par le demandeur. Les signaux de contrôle générés par le circuit 225 peuvent alors être adaptés en conséquence.

En outre, le circuit mémoire volatile 221 peut avoir plusieurs ports d'entrée-sortie (non détaillés sur les figures) pour permettre d'accélérer les transferts vers le circuit de calcul 223, et/ou, par exemple, transférer en parallèle des données du circuit mémoire non volatile 101 vers le circuit d'entrée-sortie 105 et envoyer des données vers le circuit de calcul 223.

De nombreuses applications sont susceptibles de tirer profit d'un dispositif mémoire du type décrit ci-dessus, couplant à une mémoire non volatile un circuit mémoire tampon adapté à mettre en oeuvre des opérations de calcul. A titre d'exemple non limitatif, un tel dispositif peut être avantageux pour des applications de traitement de bases de données, de chiffrement/déchiffrement de données sur disque, de réseaux de neurones, de BLAS (de l'anglais "Basic Linear Algebra Subprograms" - sous-programmes d'algèbre linéaire de base), etc.

Enfin, la mise en oeuvre pratique des modes de réalisation et variantes décrits est à la portée de la personne du métier à partir des indications fonctionnelles données ci-dessus. En particulier, la réalisation détaillée des différents circuits et liaison des dispositifs décrits est à la portée de la personne du métier à partir des indications fonctionnelles de la présente description.

## Revendications

1. Dispositif mémoire (200) comportant :
- un circuit mémoire non volatile (101) ;
- un circuit mémoire tampon (203) comprenant un circuit mémoire volatile (221) ;
- un circuit d'entrée-sortie (105) ;
- une première liaison de données (104) reliant le circuit mémoire non volatile (101) au circuit mémoire tampon (203) ;
- une deuxième liaison de données (106) reliant le circuit mémoire tampon (203) au circuit d'entrée-sortie (105) ; et
- un circuit de contrôle (225),
dans lequel le circuit mémoire tampon (203) est adapté à mettre en oeuvre des calculs ayant pour opérandes des données stockées dans le circuit mémoire volatile (221), le circuit de contrôle (225) étant adapté à recevoir des instructions via le circuit d'entrée-sortie (105), et à commander en conséquence des transferts de données entre le circuit mémoire non volatile (101) et le circuit mémoire tampon (203) via la première liaison de données (104), des transferts de données entre le circuit mémoire tampon (203) et le circuit d'entrée-sortie (105) via la deuxième liaison de données (106), et la mise en oeuvre d'opérations de calcul au sein du circuit mémoire tampon (203),
dans lequel le circuit de contrôle (225) commande le circuit mémoire tampon (203) comme une mémoire cache,
et dans lequel le circuit mémoire volatile (221) du circuit mémoire tampon (203) n'est pas mappé en mémoire, c'est-à-dire que ses adresses ne sont pas directement accessibles par un dispositif extérieur,
dans lequel le circuit de contrôle (225) est adapté à recevoir des instructions de calcul via le circuit d'entrée sortie (105), chaque instruction de calcul comprend un premier champ définissant un type d'opération à mettre en oeuvre, un deuxième champ définissant des adresses d'opérandes, et un troisième champ définissant une adresse de réécriture du résultat de l'opération.

2. Dispositif mémoire (200) selon la revendication 1, dans lequel le circuit mémoire volatile (221) du circuit mémoire tampon (203) est une mémoire SRAM.

3. Dispositif mémoire (200) selon la revendication 2, dans lequel le circuit mémoire volatile (221) du circuit mémoire tampon (203) et le circuit mémoire non volatile (101) sont intégrés sur une même puce de circuits intégrés.

4. Dispositif mémoire (200) selon l'une quelconque des revendications 1 à 3, dans lequel le circuit de contrôle (225) est adapté à commander l'exécution d'une séquence de plusieurs opérations successives de calcul au sein du circuit mémoire tampon (203) sans réécrire de résultat intermédiaire dans le circuit mémoire non volatile (101).

5. Dispositif mémoire (200) selon l'une quelconque des revendications 1 à 4, dans lequel le circuit mémoire tampon (203) intègre une table de suivi de validité des données stockées dans le circuit mémoire volatile (221) et de correspondance entre les adresses des données stockées dans le circuit mémoire volatile (221) et les adresses des données dans le circuit mémoire non volatile (101).

6. Dispositif selon la revendication 5, dans lequel le circuit de contrôle (225) est configuré pour, chaque fois qu'un accès à une donnée est requis, vérifier, au moyen de la table de correspondance, si la donnée recherchée est présente dans le circuit mémoire volatile (221), et si c'est le cas, accéder à la donnée directement dans le circuit mémoire volatile (221), sans solliciter le circuit mémoire non volatile (101).

7. Dispositif mémoire (200) selon l'une quelconque des revendications 1 à 6, dans lequel la première liaison de données (104) a une largeur supérieure à celle de la deuxième liaison de données (106).

8. Dispositif mémoire (200) selon l'une quelconque des revendications 1 à 7, dans lequel la première liaison de données (104) a une largeur égale à la taille du plus grand vecteur de données pouvant être lu en une fois dans le circuit mémoire non volatile (101).

9. Dispositif mémoire (200) selon l'une quelconque des revendications 1 à 8, dans lequel le circuit d'entrée-sortie (105) est destiné à être connecté à un bus système (150) présentant une largeur de données inférieure à la largeur de la première liaison de données (104).

10. Dispositif mémoire (200) selon l'une quelconque des revendications 1 à 9, dans lequel le circuit mémoire tampon (203) comprend un circuit de calcul (223) relié à un port d'entrée-sortie du circuit mémoire volatile (221).

11. Dispositif mémoire (200) selon l'une quelconque des revendications 1 à 10, dans lequel le circuit de contrôle (225) est adapté à lire une série d'instructions à exécuter dans une mémoire de stockage de programme interne au dispositif mémoire, le circuit de contrôle (225) étant adapté à recevoir une instruction de lancement de la série d'instructions via le circuit d'entrée-sortie (105).

12. Dispositif mémoire (200) selon l'une quelconque des revendications 1 à 11, dans lequel le circuit mémoire non volatile (101) est un circuit mémoire résistif, un circuit mémoire à changement de phase, ou un circuit mémoire magnétique.

## Patentansprüche

1. Speichervorrichtung (200), die Folgendes aufweist:
- eine nichtflüchtige Speicherschaltung (101);
- eine Pufferspeicherschaltung (203), die eine flüchtige Speicherschaltung (221) aufweist;
- eine Eingangs-/Ausgangsschaltung (105);
- eine erste Datenverbindung (104), die die nichtflüchtige Speicherschaltung (101) mit der Pufferspeicherschaltung (203) koppelt;
- eine zweite Datenverbindung (106), die die Pufferspeicherschaltung (203) mit der Eingangs-/Ausgangsschaltung (105) koppelt; und
- eine Steuerschaltung (225),
wobei die Pufferspeicherschaltung (203) eingerichtet ist zum Implementieren von Berechnungen, die als Operanden Daten aufweisen, die in der flüchtigen Speicherschaltung (221) gespeichert sind, wobei die Steuerschaltung (225) eingerichtet ist zum Empfangen von Anweisungen über die Eingangs-/Ausgangsschaltung (105) und zum entsprechenden Steuern von Datenübertragungen zwischen der nichtflüchtigen Speicherschaltung (101) und der Pufferspeicherschaltung (203) über die erste Datenverbindung (104), von Datenübertragungen zwischen der Pufferspeicherschaltung (203) und der Eingangs-/Ausgangsschaltung (105) über die zweite Datenverbindung (106) und der Implementierung von Berechnungsoperationen innerhalb der Pufferspeicherschaltung (203),
wobei die Steuerschaltung (225) die Pufferspeicherschaltung (203) wie einen Cache-Speicher steuert,
und wobei die flüchtige Speicherschaltung (221) der Pufferschaltung (203) nicht speicherabgebildet ist, d. h. ihre Adressen sind für ein externes Gerät nicht direkt zugänglich,
wobei die Steuerschaltung (225) eingerichtet ist zum Empfangen von Berechnungsanweisungen über die Eingangs-/Ausgangsschaltung (105), wobei jede Berechnungsanweisung ein erstes Feld aufweist, das einen Typ einer zu implementierenden Operation definiert, ein zweites Feld, das Operandenadressen definiert, und ein drittes Feld, das eine Adresse zum Umschreiben des Ergebnisses der Operation definiert.

2. Speichervorrichtung (200) nach Anspruch 1, wobei die flüchtige Speicherschaltung (221) der Pufferspeicherschaltung (203) ein SRAM-Speicher ist.

3. Speichervorrichtung (200) nach Anspruch 2, wobei die flüchtige Speicherschaltung (221) der Pufferspeicherschaltung (203) und die nichtflüchtige Speicherschaltung (101) auf einem gleichen integrierten Schaltungschip integriert sind.

4. Speichervorrichtung (200) nach einem der Ansprüche 1 bis 3, wobei die Steuerschaltung (225) eingerichtet ist zum Steuern der Ausführung einer Folge einer Vielzahl aufeinanderfolgender Berechnungsoperationen innerhalb der Pufferspeicherschaltung (203), ohne Umschreiben eines Zwischensergebnisses in die nichtflüchtige Speicherschaltung (101).

5. Speichervorrichtung (200) nach einem der Ansprüche 1 bis 4, wobei die Pufferspeicherschaltung (203) eine Nachschlagetabelle integriert, zum Überwachen der Gültigkeit der Daten, die in der flüchtigen Speicherschaltung (221) gespeichert sind, und zum Abgleichen der Adressen der Daten, die in der flüchtigen Speicherschaltung (221) gespeichert sind, mit den Adressen der Daten in der nichtflüchtigen Speicherschaltung (101).

6. Vorrichtung nach Anspruch 5, wobei die Steuerschaltung (225) konfiguriert ist, jedes Mal, wenn ein Zugriff auf Daten erforderlich ist, zum Überprüfen mittels der Nachschlagetabelle, ob die gesuchten Daten in der flüchtigen Speicherschaltung (221) vorhanden sind, und wenn sie vorhanden sind, zum direkten Zugreifen auf die Daten in der flüchtigen Speicherschaltung (221), ohne die nichtflüchtige Speicherschaltung (101) zu verwenden.

7. Speichervorrichtung (200) nach einem der Ansprüche 1 bis 6, wobei die erste Datenverbindung (104) eine größere Breite als die zweite Datenverbindung (106) hat.

8. Speichervorrichtung (200) nach einem der Ansprüche 1 bis 7, wobei die erste Datenverbindung (104) eine Breite hat, die gleich der Größe des größten Datenvektors ist, der auf einmal aus der nichtflüchtigen Speicherschaltung (101) gelesen werden kann.

9. Speichervorrichtung (200) nach einem der Ansprüche 1 bis 8, wobei die Eingangs-/Ausgangsschaltung (105) dazu bestimmt ist, mit einem Systembus (150) verbunden zu werden, der eine Datenbreite hat, die kleiner ist als die Breite der ersten Datenverbindung (104).

10. Speichervorrichtung (200) nach einem der Ansprüche 1 bis 9, wobei die Pufferspeicherschaltung (203) eine Berechnungsschaltung (223) aufweist, die mit einem Eingangs-/Ausgangsanschluss der flüchtigen Speicherschaltung (221) gekoppelt ist.

11. Speichervorrichtung (200) nach einem der Ansprüche 1 bis 10, wobei die Steuerschaltung (225) eingerichtet ist zum Lesen einer Reihe von Anweisungen, die in einem programmspeichernden Speicher innerhalb der Speichervorrichtung ausgeführt werden sollen, wobei die Steuerschaltung (225) eingerichtet ist zum Empfangen einer Anweisung zum Starten der Reihe von Anweisungen über die Eingangs-/Ausgangsschaltung (105).

12. Speichervorrichtung (200) nach einem der Ansprüche 1 bis 11, wobei die nichtflüchtige Speicherschaltung (101) eine resistive Speicherschaltung, eine Phasenwechselspeicherschaltung oder eine magnetische Speicherschaltung ist.

## Claims

1. Memory device (200) comprising:
- a non-volatile memory circuit (101);
- a buffer memory circuit (203) comprising a volatile memory circuit (221);
- an input-output circuit (105);
- a first data link (104) coupling the non-volatile memory circuit (101) to the buffer memory circuit (203);
- a second data link (106) coupling the buffer memory circuit (203) to the input-output circuit (105); and
- a control circuit (225),
wherein the buffer memory circuit (203) is adapted to implementing calculations having as operands data stored in the volatile memory circuit (221), the control circuit (225) being adapted to receiving instructions via the input-output circuit (105), and of accordingly controlling data transfers between the non-volatile memory circuit (101) and the buffer memory circuit (203) via the first data link (104), data transfers between the buffer memory circuit (203) and the input-output circuit (105) via the second data link (106), and the implementation of calculation operations within the buffer memory circuit (203),
wherein the control circuit (225) controls the buffer memory circuit (203) like a cache memory,
and wherein the volatile memory circuit (221) of the buffer circuit (203) is not memory-mapped, that is, its addresses are not directly accessible by an external device,
wherein the control circuit (225) is adapted to receiving calculation instructions via the input-output circuit (105), each calculation instruction comprises a first field defining a type of operation to be implemented, a second field defining operand addresses, and a third field defining an address for rewriting the result of the operation.

2. Memory device (200) according to claim 1, wherein the volatile memory circuit (221) of the buffer memory circuit (203) is a SRAM memory.

3. Memory device (200) according to claim 2, wherein the volatile memory circuit (221) of the buffer memory circuit (203) and the non-volatile memory circuit (101) are integrated on a same integrated circuit chip.

4. Memory device (200) according to any of claims 1 to 3, wherein the control circuit (225) is adapted to controlling the execution of a sequence of a plurality of successive calculation operations within the buffer memory circuit (203) without rewriting an intermediate result into the non-volatile memory circuit (101).

5. Memory device (200) according to any of claims 1 to 4, wherein the buffer memory circuit (203) integrates a lookup table for monitoring the validity of the data stored in the volatile memory circuit (221) and matching the addresses of the data stored in the volatile memory circuit (221) and the addresses of the data in the non-volatile memory circuit (101).

6. Device according to claim 5, wherein the control circuit (225) is configured to, each time an access to data is required, verify, by means of the lookup table, whether the searched data are present in the volatile memory circuit (221), and if they are, access the data directly in the volatile memory circuit (221), without using the non-volatile memory circuit (101).

7. Memory device (200) according to any of claims 1 to 6, wherein the first data link (104) has a width greater than that of the second data link (106).

8. Memory device (200) according to any of claims 1 to 7, wherein the first data link (104) has a width equal to the size of the largest data vector capable of being read at once from the non-volatile memory circuit (101).

9. Memory device (200) according to any of claims 1 to 8, wherein the input-output circuit (105) is intended to be connected to a system bus (150) having a data width smaller than the width of the first data link (104).

10. Memory device (200) according to any of claims 1 to 9, wherein the buffer memory circuit (203) comprises a calculation circuit (223) coupled to an input-output port of the volatile memory circuit (221).

11. Memory device (200) according to any of claims 1 to 10, wherein the control circuit (225) is adapted to reading a series of instructions to be executed in a program storage memory internal to the memory device, the control circuit (225) being adapted to receiving an instruction for launching the series of instructions via the input-output circuit (105).

12. Memory device (200) according to any of claims 1 to 11, wherein the non-volatile memory circuit (101) is a resistive memory circuit, a phase-change memory circuit, or a magnetic memory circuit.
